# EUROPÄISCHE PATENTSCHRIFT

(11) **EP 0 581 932 B1**
(45) Veröffentlichungstag und Bekanntmachung des Hinweises auf die Patenterteilung: **28.02.1996**
(21) Anmeldenummer: 93903906.1
(22) Anmeldetag: 04.02.1993
(51) Int. Cl.: G01D 5/20, H03M 1/00

(54) **DREHWINKELSENSOR ZUR ABSOLUTEN DREHWINKELMESSUNG ÜBER MEHRERE UMDREHUNGEN**
ANGLE OF ROTATION SENSOR FOR THE ABSOLUTE MEASUREMENT OF THE ANGLE OF ROTATION OVER SEVERAL REVOLUTIONS
DETECTEUR D'ANGLE DE ROTATION VISANT A PROCEDER A LA MESURE ABSOLUE DE L'ANGLE DE ROTATION SUR PLUSIEURS TOURS

(30) Priorität: 05.02.1992 DE 4203236
(43) Veröffentlichungstag der Anmeldung: 09.02.1994
(73) Patentinhaber: ASM AUTOMATION, SENSORIK, MESSTECHNIK GMBH, D-82008 Unterhaching (DE)
(72) Erfinder: Steinich, Klaus-Manfred, D-8025 Unterhaching (DE); Wirth, Peter, D-8000 München 90 (DE)
(74) Vertreter: Reinhard - Skuhra - Weise & Partner
(86) Internationale Anmeldenummer: EP9300257
(87) Internationale Veröffentlichungsnummer: WO9316354

(56) Entgegenhaltungen:
- DE-A- 3 734 938
- US-A- 3 446 982

## Beschreibung

Die Erfindung betrifft einen Drehwinkelsensor gemäß dem Oberbegriff des Anspruches 1.

Bekannte Sensoren werden verwendet, um Drehwinkelpositionen rotierender Teile z. B. einer Motorwelle absolut über mehrere Umdrehungen zu messen. Ihre technische Funktion liegt darin, daß sie im Gegensatz zu inkrementell und zählend arbeitenden Sensoren in jedem Betriebszustand, z. B. nach dem Einschalten oder nach Betriebsstörungen, die richtige Winkelposition ausgeben.

Ein Drehwinkelsensor dieser Art ist aus der Firmenschrift IMAS (Induktives Modulares Absolutmeßsystem) EUCRON, Leinfelden-Echterdingen bekannt und besteht aus Grob- und Fein-DrehwinkelSensorelementen, die über Getriebe nacheinander gekoppelt sind. Über einen Multiplexer, der mit den Sensorelementen einerseits und mit einer Auswerteelektronik andererseits verbunden ist, wird die Winkelinformation der einzelnen Sensorelemente sequentiell ausgewertet. Die Ansteuerung des Multiplexers und damit die Selektion eines einzelnen Sensorelements erfolgt durch verschiedene Gleichspannungspegel, die der dem Multiplexer von der Auswerteschaltung zugeführten Sensorelement-Erregerspannung überlagert werden. Der Multiplexer ist mit Hilfe von Halbleiter-Bauelementen wie Halbleiterschaltern zum Schalten der Sensorsignale und Komparatoren zur Detektierung der Gleichspannungs-Steuerpegel realisiert. Die Hilfsenergie zur Multiplexersteuerung wird mit Hilfe von Gleichrichtern aus der Sensorelement-Erregerspannung abgeleitet. Der Nachteil dieses Drehwinkelsensors besteht in der Integration von Halbleiterbauelementen am Meßort. Diese machen den Sensor empfindlich gegen Umgebungseinflüsse wie elektrische und magnetische Störfelder sowie extreme Temperaturschwankungen, wie sie bei Anwendungen im Bereich der Antriebstechnik üblich sind.

Ein weiterer Drehwinkelsensor ist in der DE 37 34 938 A1 beschrieben. Die Anordnung sieht mehrere über Getriebe untereinandergekoppelte Resolver vor. Die Übersetzungsverhältnisse sind mit 2EXP(N) festgelegt. Der Code ist einschrittig. Die Verknüpfung der Winkelinformation der einzelnen Sensorelemente erfolgt über ein redundantes Bit. Der Nachteil dieser Anordnung ist die durch die Auswerteschaltung bedingte Einschränkung auf bestimmte Übersetzungsverhältnisse der Getriebe. Dies erschwert deren Optimierung auf vorteilhafte kleine Bauformen. Ein weiterer Nachteil ist die Festlegung auf einen einschrittigen Code. Dieser muß für die Verarbeitung in in der Industrie üblichen Steuereinheiten mittels eines Codewandlers in den natürlichen Dualcode umgewandelt werden. Weiter nachteilig ist die durch eine Auswerteschaltung bedingte Einschränkung auf nur eine Bitstelle zur Verknüpfung der Winkelinformation der einzelnen Sensorelemente. Dies beschränkt die Toleranzen für die Getriebelose der Übersetzungsgetriebe auf 1/4 Umdrehung der jeweils vorausgehenden Welle. Der mechanische Aufwand für die Realisierung der Getriebe ist deshalb höher als notwendig. Ein weiterer Nachteil ist der durch die ausschließliche Verwendung von Resolvern entstehende Kostenaufwand.

Ein weiterer Sensor ist aus der DE 32 46 959 bekannt. Darin sind mehrere Sensorelemente über Differenzgetriebe mit kleinen Untersetzungsverhältnissen hintereinandergekoppelt. Der Nachteil bei der Anwendung von Differenzgetrieben an schnell drehenden Eingangswellen ist die hohe Rotordrehzahl der nacheinandergekoppelt folgenden Sensorelemente. Dies beansprucht deren Lagerung und bedingt eine aufwendige mechanische Auslegung.

Sowohl aus der DE 32 46 959 als aus der DE 37 34 938 ist die sequentielle Auswertung der Sensorelemente mit Hilfe des Multiplexverfahrens bekannt. Eine störsichere Realisierungsform eines Multiplexers mit geringem Aufwand ist jedoch nicht angegeben.

Aus der DE 29 07 672 ist die Anwendung von Ringkerndrosseln zum sequentiellen Auswerten von Informationsbit eines oder mehrerer Winkelcodierer bekannt. Nachteilig ist die sehr aufwendige digitale Realisierung der Winkelcodierer mit Hilfe magnetisch codierender Einzelelemente und die geringe erreichbare Winkelauflösung.

Optische Absolut-Winkelsensoren sowie kapazitive Winkelsensoren sind aus der DE 29 38 318 und DE 37 11 062 bekannt. Sie benutzen Glasscheiben mit optisch codierten Teilungen bzw. feststehende und rotierende Kondensatorplatten zur Kodierung von Winkelinformation. Der Nachteil der optischen und kapazitiven Sensoren ist ihre Empfindlichkeit gegen elektrische und magnetische Störfelder sowie extreme Temperaturschwankungen aufgrund der integrierten Signalelektronik. Ein weiterer Nachteil der optischen Sensoren ist die Empfindlichkeit der Glasscheiben gegen Erschütterungen und Verschmutzung.

Der Erfindung liegt die Aufgabe zugrunde, einen Drehwinkelsensor für das Messen von Drehwinkeln über mehrere Umdrehungen zu schaffen, der bei guter Auflösung gegenüber elektrischen, magnetischen, elektromagnetischen, thermischen und radioaktiven Störeinwirkungen sowie mechanischen Erschütterungen weitgehendst unbeeinflußt ist.

Diese Aufgabe wird erfindungsgemäß durch die Merkmale im kennzeichnenden Teil des Anspruches 1 gelöst.

Weitere Ausgestaltungen ergeben sich aus den abhängigen Ansprüchen.

Gemäß der Erfindung werden als Schaltelemente der Zeitmultiplexeinrichtung Ringkerndrosseln eingesetzt. Die Anwendung von induktiven Schaltelementen zur Realisierung der Multiplextechnik ermöglicht vorteilhaft die Einsparung von Verkabelungsaufwand, ohne die Robustheit bzw. Empfindlichkeit des Sensors zu beeinträchtigen.

Die Ringkerndrosseln weisen eine Schaltwicklung und eine geschaltete Wicklung auf. Der magnetische Werkstoff der Ringkerndrosseln weist eine Magnetisierungskurve mit Abschnitten annähernd konstanter, hoher differentieller Permeabilität und annähernd konstanter, niedriger differentieller Permeabilität auf. Dies ermöglicht durch die Bildung genügend hoher induktiver Widerstände im ausgeschalteten bzw. gesperrten Zustand und durch die Bildung genügend niedriger induktiver Widerstände im einbzw. durchgeschalteten Zustand die Drosseln als Schalterelemente für Wechselspannungen zu benutzen.

Der magnetische Werkstoff der Ringkerndrosseln weist eine niedrige Koerzitivfeldstärke auf. Dies ermöglicht es, im "eingeschalteten" Zustand der Drossel auftretende Verzerrungen der zu schaltenden Wechselspannung gering zu halten.

Die über Verbindungsleitungen an den Sensor angeschlossene elektronische Auswerteschaltung kann entfernt vom Meßort angeordnet werden. Dies ermöglicht es vorteilhafterweise, die gegen Umgebungseinflüsse empfindliche Auswerteschaltung in einem Schaltschrank unterzubringen.

Der Drehwinkelsensor besteht vorteilhafterweise ausschließlich aus induktiven Bauelementen und ist damit bezüglich seiner elektromagnetischen, thermischen und mechanischen Umweltverträglichkeit besonders robust bzw. stabil.

Die Verknüpfung der digitalen Winkelinformation von Resolver und nachgeschalteten Sensorelementen erfolgt durch eine elektronische Auswerteschaltung. Da die Analog/Digital-Umsetzung der Winkelwerte der Grob-Sensorelemente mit der gleichen Auflösung wie bei den Fein-Sensorelementen durchgeführt wird, steht mehr als nur ein redundantes Informationsbit für die Verknüpfungsrechnung zur Verfügung. Dies ermöglicht eine größere Toleranz durch Getriebelose (±1/2 Umdrehung der Getriebeeingangswelle gegenüber ±1/4 Umdrehung bei Nutzung nur eines redundanten Informationsbit) zuzulassen oder für eine bestimmte Toleranz durch Getriebelose höhere Untersetzungsverhältnisse zu wählen. Des weiteren wird durch die erhöhte Auflösung der Winkelinformation der Grob-Sensorelemente eine Fehlererkennung möglich, die den Abnutzungsgrad des Getriebes erkennen läßt. Eine Einschränkung der Getriebeübersetzung auf bestimmte oder untereinander gleiche Übersetzungsverhältnisse ist aufgrund der programmgesteuerten Auswerteschaltung nicht gegeben. Dies ermöglicht vorteilhaft die mechanische Baugröße des Getriebes zu minimieren. Die Auswertung aller Winkelsensorelemente erfolgt abhängig vom Betriebszustand, z. B. bei Einschalten der Versorgungsspannung. Im Normalbetrieb wird nur das Fein-Winkel-Sensorelement ausgewertet und die Anzahl ganzer Umdrehungen inkrementell durch Übertragszählung ermittelt.

Eine bevorzugte Ausführungsform der Erfindung wird nachfolgend zur Erläuterung weiterer Merkmale und Vorteile anhand der Zeichnung beschrieben. Es zeigen:
- Fig. 1: eine schematische Darstellung des Drehwinkelsensors mit Auswerteschaltung,
- Fig. 2: den Amplitudenverlauf der Ausgangsspannung des Drehwinkelsensors,
- Fig. 3: eine bevorzugte Ausführungsform eines induktiven Schaltelementes,
- Fig. 4: die Kennlinie des induktiven Schaltelements, und
- Fig. 5: eine schematische Ausführung des Multiplexers mit Schaltelementen.

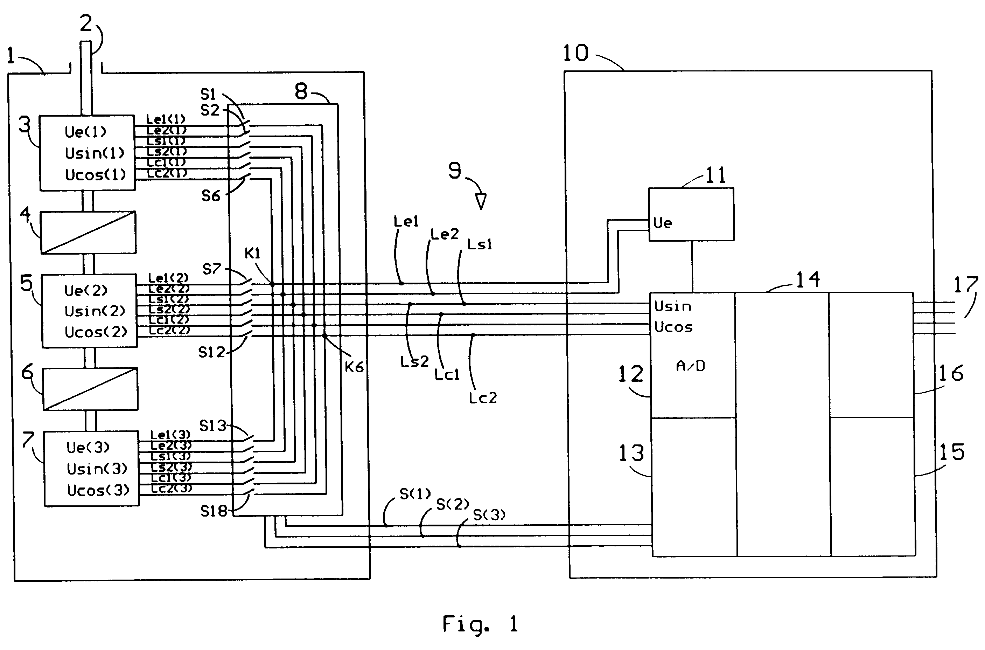

Fig. 1 zeigt einen Drehwinkelsensor 1 und eine zugehörige elektronische Auswerteschaltung 10. Ein Resolver 3 dient als erstes Fein-Winkelsensorelement des Drehwinkelsensors und ist direkt mit einer Arbeitswelle 2 gekoppelt, deren mechanische Winkelposition zu messen ist.

Über Untersetzungsgetriebe 4,6 sind aufeinanderfolgend mehrere Grob-Winkel-Sensorelemente 5, 7 an die Welle angekoppelt. Jedem der Sensorelemente 3,5,7 wird über zwei Eingangsleitungen Le1(i), Le2(i) eine Erreger-Wechselspannung Ue(i) zugeführt. Jedes der Sensorelemente 3,5,7 gibt über zwei Ausgangsleitungen Ls1(i), Ls2(i) eine Ausgangsspannung Usin(i) und über weitere zwei Ausgangsleitungen Lc1(i), Lc2(i) eine Ausgangsspannung Ucos(i) ab. Die Ein- und Ausgangsleitungen der Sensorelemente 3,5,7 sind auf einen vorzugsweise im Drehwinkelsensor angeordneten Multiplexer 8 angeschlossen. Der Multiplexer 8 ist über ein Kabel 9, das vorzugsweise sechs Verbindungsleitungen Le1, Le2, Ls1, Ls2, Lc1, Lc2 und mehrere Steuerleitungen S(i) aufweist, mit der elektronischen Auswerteschaltung 10 verbunden.

Die Auswerteschaltung 10 weist einen Oszillator 11 zur Erzeugung einer Erregerspannung Ue für die Winkel-Sensorelemente, einen Analog-Digital Wandler 12 zur Demodulation und Analog-Digital-Wandlung der Sensorsignale Usin und Ucos, eine Ansteuerschaltung 13 zur Ansteuerung der Schaltelemente des Multiplexers, eine programmierbare Rechen- und Steuereinheit bzw. CPU 14 zur sequentiellen Auswertung aller Signale der Winkel-Sensorelemente und einen Speicher 15 zur Zwischenspeicherung der Ausgangssignale der einzelnen Sensorelemente 3,5,7 auf.

Wie aus Fig. 1 hervorgeht, sind die Erreger-Wechselspannung liefernden Leitungen Le1 und Le2 mit dem Oszillator 11 verbunden, während die Ausgangsleitungen, welche die Ausgangsspannung Usin(i) und Ucos(i) liefern, an den A/D-Wandler 12 angeschlossen sind.

Mit 16 ist eine Treiberschaltung bezeichnet, die ausgangsseitig Signalleitungen 17 aufweist, über welche der absolute Winkelwert an eine übergeordnete Kontroll- und/oder Regeleinheit übermittelt werden.

Aus Fig. 1 ist ersichtlich, daß die Ausgangssignale der Sensorelemente 3,5,7 über beispielsweise sechs, im Multiplexer 8 zusammengeschaltete Leitungen an die Auswerteschaltung 10 angelegt werden, welche die Ausgangssignale des Drehwinkelsensors 1 nach Auswertung aufbereitet, um über eine Kontroll- oder Regelschaltung den die Arbeitswelle 2 antreibenden, in der Zeichnung nicht dargestellten Motor zu steuern oder zu regeln.

Der A/D-Wandler 12 empfängt vom Multiplexer 8 bei der vorstehend erläuterten Ausführungsform Analogsignale, die in Digitalsignale konvertiert werden.

Die Rechen- und Steuereinheit 14 empfängt die Drehwinkelinformation der einzelnen Sensorenelemente 3,5,7 vorzugsweise als binäre Worte und bewirkt eine Zwischenspeicherung. Die Rechen- und Steuereinheit 14 setzt die Ausgangssignale der Sensorelemente 3,5,7 in an sich bekannter Weise zu einer absoluten Winkelinformation zusammen, welche vorzugsweise mehrere Arbeitswellenumdrehungen berücksichtigt.

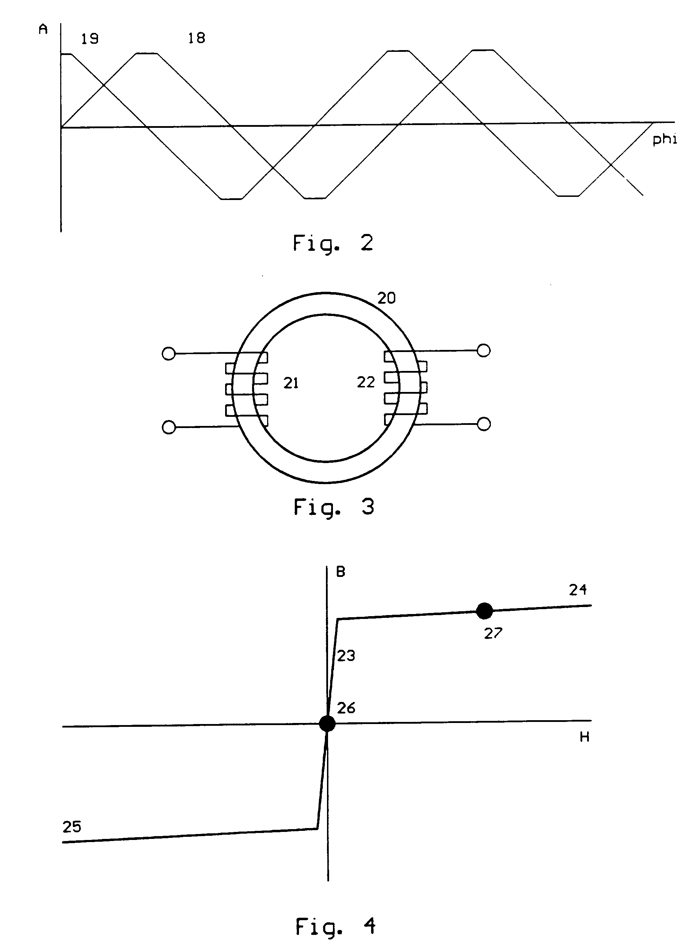

Fig. 2 zeigt den Amplitudenverlauf A der Ausgangsspannungen Usin 18 und Ucos und 19 der Sensorelemente 3,5,7 abhängig von der Winkelstellung des Rotors bzw. der Arbeitswelle 2 und entsprechen etwa einer Sinus- und Cosinusfunktion.

In Fig. 3 ist eine bevorzugte Ausführungsform eines Schaltelements für den Multiplexer 8 veranschaulicht. Ein Ringkern 20 aus weichmagnetischem Material enthält eine Schaltwicklung 21 und eine geschaltete Wicklung 22, die vorzugsweise entsprechend Fig. 3 einander gegenüberliegend auf dem Ringkern 20 gewickelt sind. Jeweils ein Schaltelement S1 bis S18 der in Verbindung mit Fig. 3 beschriebenen Art ist im Multiplexer 8 von jeweils einem der dort dargestellten Leitungsverknüpfungsknoten K1 bis K6 angeordnet, wodurch in zeitmultiplexerweise die Ausgangssignale auf den Leitungen Le1(i) bzw. Le2(i), ... Lc2(i) der Sensoren 3,5 und 7 zur Auswerteschaltung 10 gegeben werden. Mit anderen Worten bedeutet dies, daß gemäß der Erfindung der Mulitplexer 8 bei dem dargestellten Ausführungsbeispiel je Sensor sechs derartige Schaltelemente aufweist, was von der Zahl der Eingangsleitungen abhängt, welche mit den Sensorelementen 3,5,7 verbunden sind.

Fig. 4 zeigt die Arbeitsweise des Schaltelements anhand der Magnetisierungskennlinie des Ringkerns. Die Anwendung von Ringkerndrosseln als Schaltelement erfordert hohe Unterschiede der differentiellen Permeabilität in den einzelnen Arbeitspunkten auf der Magnetisierungskennlinie bei gleichzeitig geringen Ummagnetisierungsverlusten. Dies wird erreicht durch die Anwendung von weichmagnetischem Magnetmaterial mit Z-förmiger Magnetisierungskennlinie. Die Magnetisierungkurve, welche die magnetische Flußdichte B in Abhängigkeit von der magnetischen Feldstärke H angibt, weist gemäß Fig. 4 einen annähernd geradlinigen, steilen Abschnitt 23 und zwei annähernd geradlinige, flache Abschnitte 24,25 auf. Die Koerzitivfeldstärke des Ringkernmaterials ist gering. Damit ist das magnetische Material des Ringkernes nahezu hysteresefrei und erzeugt geringe Ummagnetisierungsverluste.

Die Schaltwirkung der geschaltete Wicklung 22 wird durch Änderung ihres induktiven Widerstandes erzielt. Dies wird erreicht durch Vormagnetisierung des Ringkerns über das durch einen Steuerstrom erzeugte Magnetfeld der Schaltwicklung 21. Bei unbestromter Schaltwicklung liegt der Arbeitspunkt 'AUS' 26 der geschalteten Wicklung 22 im Koordinatenursprung der Magnetisierungskennlinie mit großer differentieller Permeabilität. Daraus ergibt sich ein hoher induktiver Widerstand für den Schaltzustand 'AUS'. Fließt ein genügend großer Gleichstrom durch die Schaltwicklung 21, ergibt sich aufgrund der Vormagnetisierung ein Arbeitspunkt 'EIN' 27 der geschalteten Wicklung auf dem flachen Teil der Kennlinie mit niedriger differentieller Permeabilität. Daraus ergibt sich ein entsprechend niedriger induktiver Widerstand für den Schaltzustand 'EIN'. Die gesteuerte Spule 22 wird ausschließlich in den zwei vordefinierten Arbeitspunkten 'EIN' und 'AUS' betrieben. Der Spannungsabfall über der Impedanz der geschalteten Wicklung 22 in deren eingeschaltetem Zustand verfälscht die Meßsignalspannungen. Aufgrund der ratiometrischen Auswertung der Signale Usin(i) und Ucos(i) wird dieser wie auch der durch den Widerstand der Zuleitung verursachte Fehler eliminiert.

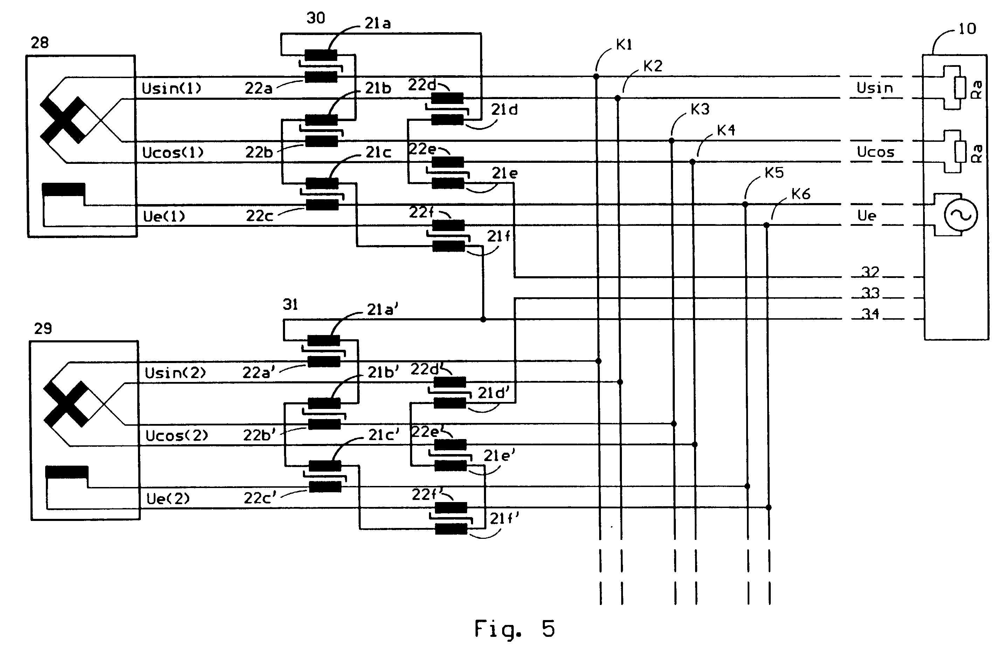

Fig. 5 zeigt ein Ausführungsbeispiel der Verschaltung von zwei Sensorelementen 28, 29 mit den Ausgangsspannungen Usin(1), Ucos(1) und Usin(2), Ucos(2) und den Erregerspannungen Ue(1) bzw. Ue(2). Jeweils eine der beiden Gruppen 30, 31 mit je sechs induktiven Schaltelementen wird durch Ströme über Steuerleitungen 32,34 und 33,34 angesteuert. Die auf diese Weise selektierten Ausgangsspannungen des ausgewählten Sensorelements 28 oder 29 werden auf die Verbindungsleitungen zur Auswerteelektronik 10 niederohmig durchgeschaltet.

Aus der Darstellung nach Fig. 5 ergibt sich, daß durch entsprechende Stromsignale auf den Steuerleitungen 32, 33, 34 die jeweiligen Schaltwicklungen 21a, 21b bis 21f bzw. 21a' bis 21f' angesteuert werden und auf diese Weise die Signale der zugehörigen geschalteten Wicklung 22a, 22b usw. auf Durchlaß geschaltet werden. Ein Einschaltsignal auf den Steuerleitungen 32 und 34 bewirkt damit die Ansteuerung der Schaltwicklungen 21a, 21b usw. der oberen Gruppe an Schaltelementen und ein Einschaltsteuersignal auf den Steuerleitungen 33 und 34 die Ansteuerung der Schaltwicklungen 21a', 21b' usw. der in Fig. 5 unteren Gruppe, wobei die obere Gruppe im Sensorelement 28 und die untere Gruppe dem Sensorelement 29 zugeordnet ist.

Die Verknüpfungsknoten der einzelnen Leitungen sind entsprechend Fig. 1 auch in Fig. 5 mit K1 bis K6 bezeichnet und verbinden die Ausgangsleitungen der jeweiligen, einander zugeordneten geschalteten Wicklungen 22 der Sensorelemente.

Das Verhältnis der differentiellen Permeabilität des Ringkerns im eingeschalteten Zustand zur differentiellen Permeabilität im ausgeschaltetem Zustand bestimmt das Schaltverhältnis SV = Zaus/ Zein der geschalteten Spule für die Schaltzustände "EIN" und "AUS" (SV: Schaltverhältnis, Zaus: Wechselstromwiderstand im Zustand "AUS", Zein: Wechselstromwiderstand im Zustand "EIN"). Da der Wechselstromwiderstand im ausgeschalteten Zustand nicht unbegrenzt groß und im eingeschalteten Zustand nicht unbegrenzt klein wird, addieren sich auf einem Verknüpfungsknoten die von den eingeschalteten und ausgeschalteten Sensorelementen gelieferten Spannungen entsprechend dem Schaltverhältnis SV der Schaltelemente. Seien im Ausführungsbeispiel nach Fig. 5 die Schaltelemente 22a bis 22f eingeschaltet und die Schaltelemente 22a' bis 22f' ausgeschaltet, so bildet sich die Spannung Usin über den Verknüpfungsknoten K1 - K2 aus der Addition der Spannungen Usin(1) und Usin(2) anteilig nach dem Schaltverhältnis SV der beteiligten Schaltelemente. Um den daraus resultierenden Meßfehler gering zu halten, muß SV genügend groß gewählt werden. Dies erfolgt durch Auswahl eines geeigneten Magnetmaterials und durch Bemessung der Wicklungen der geschalteten Ringkernspulen (22a bis 22f, 22a' bis 22f').

Die Anpassung der Meßsignale Usin, Ucos an die Auswerteelektronik 10 erfolgt hochohmig über den Widerstand Ra, so daß kein Fehler durch zusätzliche Strombelastung des Meßzweiges entsteht (Fig.5).

Die Koerzitivfeldstärke ist ein Maß für die Hysterese des Magnetmaterials. Hysterese beeinflußt den induktiven Widerstand der gesteuerten Spule für den Schaltzustand "AUS" des Schaltelements. Weiterhin wird durch Ummagnetisierungsverluste dem Meßzweig Energie entzogen und damit die Signalamplitude abgeschwächt. Die Koerzitivfeldstärke des Ringkern Magnetmaterials muß demnach klein genug gewählt werden, daß darauf resultierende Meßsignalfehler in der Größenordnung der Meßgenauiggkeit der Sensorelemente liegen.

Die Vorteile der Erfindung sind gegeben durch die besondere Robustheit bezüglich ihrer elektromagnetischen, thermischen und mechanischen Umweltverträglichkeit bei gleichzeitig kostengünstiger Fertigungsweise und hoher Meßgenauigkeit.

Gemäß einer vorteilhaften Ausgestaltung der Erfindung wird die Auswerteschaltung 10 vom Meßort entfernt angeordnet, d.h. sie liegt nicht in unmittelbarer Nähe des Motors oder der Sensorelemente.

## Patentansprüche

1. Drehwinkelsensor zur absoluten Drehwinkelmessung über mehrere Umdrehungen, mit einem mit der zu überwachenden Drehwelle verbundenen Resolver als Fein-Winkelsensorelement und mehreren jeweils über ein Untersetzungsgetriebe angekoppelten induktiven Grob-Winkelsensorelementen, einem Analog-Digital Wandler zur Demodulation und Umsetzung der analogen Wechselspannungsausgangssignale der induktiven Sensorelemente in ein binäres Datenwort, einem Zeitmultiplexer, der sequentiell die Analogsignale der einzelnen Sensorelemente dem Analog-Digital-Wandler zuführt, einer elektronischen Auswerteschaltung, welche die als binäre Worte vorliegende Drehwinkelinformation der einzelnen Sensorelemente zwischenspeichert und zu einer absoluten Winkelinformation über mehrere Umdrehungen zusammensetzt, **dadurch gekennzeichnet,** daß als Schaltelemente der Zeitmultiplexeinrichtung Ringkerndrosseln (21,22) vorgesehen sind, und daß die Ringkerndrosseln eine Schaltwicklung (24) und eine geschaltete Wicklung (22), über die das Analogsignal des jeweiligen Sensorelements geleitet wird, aufweisen.

2. Drehwinkelsensor nach Anspruch 1, dadurch gekennzeichnet, daß der magnetische Werkstoff der Ringkerndrosseln (21, 22) eine Magnetisierungskurve mit Abschnitten annähernd konstanter hoher differentieller Permeabilität und annähernd konstanter niedriger differentieller Permeabilität aufweist.

3. Drehwinkelsensor nach Anspruch 1 oder 2, dadurch gekennzeichnet, daß der magnetische Werkstoff der Ringkerndrosseln eine niedrige Koerzitivfeldstärke aufweist.

4. Drehwinkelsensor nach einem der vorangehenden Ansprüche, dadurch gekennzeichnet, daß die Auswerteschaltung (10) entfernt vom Meßort angeordnet ist.

## Claims

1. Angle of rotation sensor for the absolute measurement of the angle of rotation over several revolutions, with a resolver as a precision angle sensor element connected to the rotating shaft to be monitored and several coarse inductive angle sensor elements each coupled by means of a reduction gear, an analog-to-digital converter for the demodulation and conversion of the analog a.c. voltage output signals of the inductive sensor elements into a binary data word, a time multiplexer which feeds the analog signals of the individual sensor elements sequentially to the analog-to-digital converter, an electronic evaluation circuit which stores temporarily the angle of rotation information of the individual sensor elements existing as binary words and assembles it into absolute angle information over several revolutions, characterised in that toroidal core chokes (21, 22) are provided as circuit components of the time multiplexing device, and that the toroidal core chokes comprise a switching winding (24) and a switched winding (22), by means of which the analog signal of the respective sensor element is transmitted.

2. Angle of rotation sensor according to claim 1, characterised in that the magnetic material of the toroidal core chokes (21, 22) exhibits a magnetization curve with sections of approximately constant high differential permeability and approximately constant low differential permeability.

3. Angle of rotation sensor according to claim 1 or 2, characterised in that the magnetic material of the toroidal core chokes has a low coercive field strength.

4. Angle of rotation sensor according to one of the preceding claims, characterised in that the evaluation circuit (10) is disposed remote from the measuring point.

## Revendications

1. Détecteur d'angle de rotation pour la mesure absolue d'un angle de rotation sur plusieurs tours, comportant un résolveur connecté à l'arbre rotatif à contrôler comme élément de détection d'angle fine et plusieurs éléments inducteurs de détection grossière couplés respectivement via un démultiplicateur, un convertisseur analogique/numérique pour démoduler et convertir les signaux de sortie de tensions alternatives analogiques des éléments de détection inductifs en un mot de données binaires, un multiplexeur temporel qui achemine en séquence les signaux analogiques des éléments de détection individuels au convertisseur analogique/numérique, un circuit d'évaluation électronique qui bufférise les informations d'angle de rotation, présentes sous forme de mots binaires, données par les éléments de détection individuels et les combine en informations d'angle absolu sur plusieurs rotations, caractérisé en ce que l'on prévoit comme éléments de commutation du dispositif de multiplexage temporel des bobines toriques (21, 22) et en ce que les bobines toriques présentent un enroulement de commutation (24) et un enroulement commuté (22) par lesquels le signal analogique de l'élément de détection respectif est acheminé.

2. Détecteur d'angle de rotation selon la revendication 1, caractérisé en ce que le matériau magnétique des bobines toriques (21, 22) présente une courbe d'aimantation avec des sections de perméabilité différentielle élevée approximativement constante et de perméabilité différentielle basse approximativement constante.

3. Détecteur d'angle de rotation selon la revendication 1 ou 2, caractérisé en ce que le matériau magnétique des bobines toriques présente une force coercitive de faible intensité.

4. Détecteur d'angle de rotation selon l'une quelconque des revendications précédentes, caractérisé en ce que le circuit d'évaluation (10) est agencé à distance du point de mesure.
